# EUROPEAN PATENT APPLICATION

(11) **EP 1 522 928 A2**
(43) Date of publication of application: **13.04.2005**
(21) Application number: 04256204.1
(22) Date of filing: 07.10.2004
(51) Int. Cl.: G06F 12/02

(54) **Priority-based flash memory control apparatus for XIP in serial flash memory, memory management method using the same, and flash memory chip thereof**

(30) Priority: 08.10.2003 KR 2003069952
(71) Applicant: Samsung Electronics Co., Ltd., Suwon-si, Gyeonggi-do (KR)
(72) Inventor: Park, Chan-ik, Seoul (KR)
(74) Representative: Robinson, Ian Michael

(57) **Abstract**

A priority-based flash memory control apparatus (500) for XIP in a serial flash memory (100), a memory management method using the same, and a memory chip thereof. Efficient memory management is provided by assigning priorities to respective pages of a serial flash memory (100) and storing the pages retrieved from the serial flash memory (100) in a system memory (700) or cache memory (523) according to their priority. A memory management method using the flash memory control apparatus (500) according to the present invention includes, if a request for reading data at a given logical address is received from a main control unit (300), searching for the data at the corresponding logical address by referring to a predetermined address translation table; and reading the data at the corresponding logical address from a system memory (700) or a cache memory (523) and transmitting the read data to the main control unit (300), depending on the results of the search.

## Description

The present invention relates to a priority-based flash memory control apparatus for XIP (eXecute In Place) in a serial flash memory, a memory management method using the same, and a memory chip thereof. More particularly, the present invention relates to improvement of system performance through efficient memory management by assigning priorities to respective pages of a serial flash memory and storing the pages retrieved from the serial flash memory in a system memory or cache memory according to their priority.

Generally, a flash memory is a non-volatile memory device from/in which data can be electrically deleted/written again. The flash memory has lower power consumption and a smaller size than those of a magnetic disk memory-based storage device. For this reason, the flash memory has been actively researched and developed as an alternative to the magnetic disk memory.

In particular, it is expected that flash memories will be widely popularized as storage devices for mobile computing devices such as digital cameras, mobile phones, and personal digital assistants (PDAs).

Depending on manufacturing methods, flash memories can be roughly classified into a parallel flash memory with a structure in which cells are positioned in parallel between bit lines and ground lines, and a serial flash memory with a structure in which cells are positioned in series between bit lines and ground lines.

Among them, the serial flash memory has advantages in that it has a high write rate and is relatively inexpensive and in that it can be easily manufactured to have high capacity, compared with the parallel flash memory. Thus, the serial flash memory has been widely used to store large volumes of data.

Contrary to the magnetic disk memory from/into which data can be freely read/written, a delete operation is performed on a block basis and a read/write operation is performed on a page basis in the serial flash memory since the execution bases of the delete and read/write operations are inconsistent with each other.

Accordingly, the serial flash memory has a disadvantage in that it does not provide the execute-in-place (hereinafter, referred to as "XIP") function of directly executing written data without requiring transfer of the data to a system memory.

Recently, however, the serial flash memory has been adapted to support the XIP function by using a predetermined controller.

Specifically, if power is applied to a system, the controller reads a page containing a boot code necessary for initial booting of the system from a serial flash memory and then stores the read page in a buffer. If the boot code is requested by a main control unit of the system, the controller reads only the boot code and then provides it to the main control unit.

Furthermore, the controller reads a page containing desired data in response to a control command received from the main control unit, extracts the desired data from the read page and then transmits the extracted data to the main control unit. The controller also stores the read page in a cache memory so that the data of the read page can be efficiently accessed.

In supporting the XIP function of the serial flash memory in such a manner, the controller repeatedly performs the process of transmitting desired data to the main control unit and storing a page read from the serial flash memory in the cache memory, in response to a request by the main control unit. Therefore, read pages are continuously accumulated in the cache memory during the repeated processes.

In these processes, the cache memory performs page replacement according to a predetermined replacement algorithm (for example, least recently used (LRU), first in first out (FIFO), or random). In this case, a direct mapping technique is widely used as a mapping method for page replacement.

A direct mapping type cache memory stores a read page in an index of the cache memory corresponding to the memory address of the read page. If there is conflict of data of the read page with data of a previously written page during storing the read page in the cache memory, the previously written page is deleted and the newly read page is stored in accordance with a replacement algorithm.

In this case, if the main control unit of the system requests data of a deleted page, there occurs a cache miss representing the fact that the data requested by the main control unit are not present in the cache memory. Therefore, the controller should access the serial flash memory again and then refer to the desired data, resulting in waste of a large number of cycles.

In other words, due to such inefficient memory management, data including timer interrupt that frequently happens in a system, time-critical interrupt for processing communications, a system library that is frequently retrieved, and real-time applications that must be executed within a predetermined period of time are treated equally with other general code pages. Accordingly, there are problems in that this process lowers the overall performance of the system and limits the real-time properties of the system.

Therefore, there is a need for an efficient memory management method of managing pages read from a serial flash memory according to the significance of data of the respective pages.

The present invention is conceived to address the aforementioned or other problems of the prior art.

According to the present invention there is provided an apparatus and method as set forth in the appended claims. Preferred features of the invention will be apparent from the dependent claims, and the description which follows.

A primary object of the present invention is to improve the performance of a system through efficient memory management, by assigning priorities to respective pages in a serial flash memory and storing the pages read from the memory in a system memory or a cache memory according to their priority.

Another object of the present invention is to reduce a miss ratio in a cache memory by preventing a cache miss from occurring in a cache memory through data processing according to priority.

A further object of the present invention is to preserve the real-time properties of a system by reducing a miss ratio in a cache memory to prevent waste of cycles.

According to the present invention, priorities are assigned to respective pages in a serial flash memory. If data at a given logical address are requested by a main control unit, a flash memory control apparatus searches for desired data by referring to an address translation table consisting of mapping information of a system memory.

Depending on the results of the search, the flash memory control apparatus reads data at a relevant logical address in a system memory or a cache memory and then transmits the read data to the main control unit, or reads a page containing the corresponding data from a serial flash memory and then transmits the requested data to the main control unit.

Furthermore, the flash memory control apparatus stores pages, which have been read from the serial flash memory, in the system memory or the cache memory according to their priority, and writes changed mapping information in a relevant address translation table.

In the present invention, an address translation table consisting of mapping information of a system memory is defined as a page address translation table (hereinafter, referred to as "first PAT") in which mapping information on pages transferred from a cache memory or a serial flash memory to a system memory to be stored therein according to priority is written. An address translation table consisting of mapping information of a cache memory is defined as a page address translation table (hereinafter, referred to as "second PAT") in which mapping information on pages transferred from a serial flash memory to a cache memory to be stored therein according to priority is written.

Further, according to the present invention, priority is determined based on a ratio of access to main data of a page, significance or the like, and is represented by predetermined degrees depending on the level of determined priority.

According to one aspect of the present invention, there is provided a serial flash memory, comprising a sector representing a data region which consists of a plurality of pages and in which data are stored; and a sector representing a spare region having information on logical addresses of the data region. Each of the pages consists of a data section with main data written therein and a spare section in which priorities assigned to the main data are written.

According to another aspect of the present invention, there is provided a priority-based flash memory control apparatus for XIP in a serial flash memory, wherein when a main control unit requests the data at a given logical address, the desired data are searched by referring to a predetermined address translation table, and depending on the results of the search, the corresponding data are read from a system memory or a cache memory and then transmitted to the main control unit, or a page containing the corresponding data is read from the serial flash memory and then transmitted to the main control unit.

In the flash memory control apparatus, the page read from the serial flash memory may be stored in the system memory or the cache memory according to its priority and changed mapping information is written in the address translation table.

According to a further aspect of the present invention, there is provided a priority-based flash memory management method for XIP in a serial flash memory, comprising the steps of, if a request for reading data at a given logical address is received from a main control unit, searching for the data at the corresponding logical address by referring to a predetermined address translation table; and reading the data at the corresponding logical address from a system memory or a cache memory and transmitting the read data to the main control unit, depending on the results of the search.

The method may further comprise the step of reading a page containing the corresponding data from the serial flash memory and transmitting the requested data to the main control unit, depending on the results of the search. In addition, the method may further comprise the step of storing the page read from the serial flash memory in the system memory or the cache memory according to its priority and writing changed mapping information in the address translation table.

According to a still further aspect of the present invention, there is provided a flash memory chip, comprising a serial cell-type serial flash memory that consists of pages, each of which has a data section in which main data are written and a spare section in which priorities assigned to the main data are written; and a flash memory control apparatus for storing pages read from the serial flash memory in a system memory or a cache memory according to their priorities and writing changed mapping information in a predetermined address translation table.

The above and other objects, features and advantages of the present invention will become apparent from the following description of preferred embodiments given in conjunction with the accompanying drawings, in which:
Figure 1 schematically shows a page structure of a serial flash memory according to one embodiment of the present invention;
Figure 2 is a block diagram schematically showing the configuration of a serial flash access system according to one embodiment of the present invention;
Figure 3 is a block diagram schematically showing a flash memory control apparatus shown in Figure 2;
Figure 4 schematically shows a read command-processing configuration in a controller;
Figure 5 schematically shows a page-processing configuration depending on priority in the controller;
Figure 6 is a flowchart schematically illustrating a memory management method using a priority-based flash memory control apparatus for XIP in a serial flash memory according to one embodiment of the present invention;
Figure 7 is a block diagram schematically showing a memory management configuration using the priority-based flash memory control apparatus for XIP in the serial flash memory according to another embodiment of the present invention; and
Figure 8 is a block diagram schematically showing a memory management configuration using the priority-based flash memory control apparatus for XIP in the serial flash memory according to a further embodiment of the present invention.

Hereinafter, a priority-based flash memory control apparatus for XIP in a serial flash memory, a memory management method using the same, and a memory chip thereof according to the present invention will be described in detail with reference to the accompanying drawings.

Although the priority-based flash memory control apparatus for XIP in a serial flash memory, the memory management method using the same, and the memory chip thereof according to the present invention will be described below as being implemented with a flash memory control apparatus including a predetermined address translation table, it is merely illustrative. Those skilled in the art can understand that it is possible to make various modifications and equivalents of a memory management method of storing pages read from a serial flash memory in a system memory according to previously assigned priorities and writing changed mapping information in an address translation table for a system memory, whereby desired data can be searched by referring to the address translation table for the system memory upon performing a read operation in response to a request by a main control unit.

A serial flash memory is mainly divided into a sector representing a data region and a sector representing a spare region. Data are written in the data region. General information on a serial flash memory, such as the model of the flash memory model and a memory capacity, and mapping information between physical addresses of data written in the data region and logical addresses corresponding thereto are written in the spare region.

Data written in the data region may include a boot code for booting an operating system (OS), OS/application programs, data for executing programs written in an OS region, and data input by a user or signals generated while the OS operates.

Such a data region includes a plurality of blocks that are divided in a predetermined size. Each of the blocks includes a plurality of pages.

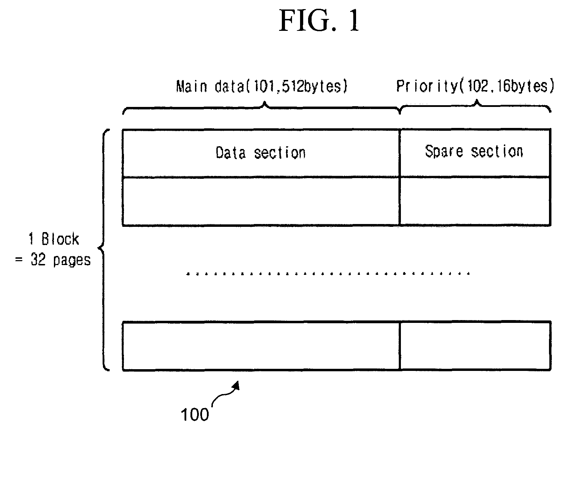

Figure 1 schematically shows a page structure of a serial flash memory according to one embodiment of the present invention.

As shown in Figure 1, a page of the serial flash memory 100 is mainly divided into a data section in which main data are written, and a spare section in which priorities assigned to the main data are written.

Priority is determined depending on a ratio of access to main data of a page, significance thereof, and represented by predetermined degrees depending on the level of determined priority.

That is, if priority is determined to have two levels, it is represented by High (H) or Low (L).

For example, in a case where the serial flash memory 100 is a NAND flash memory consisting of 528 bytes, the data region of the serial flash memory 100 includes a plurality of blocks each of which has 32 pages.

Each of the pages includes a data section of 512 bytes and a spare section of 16 bytes.

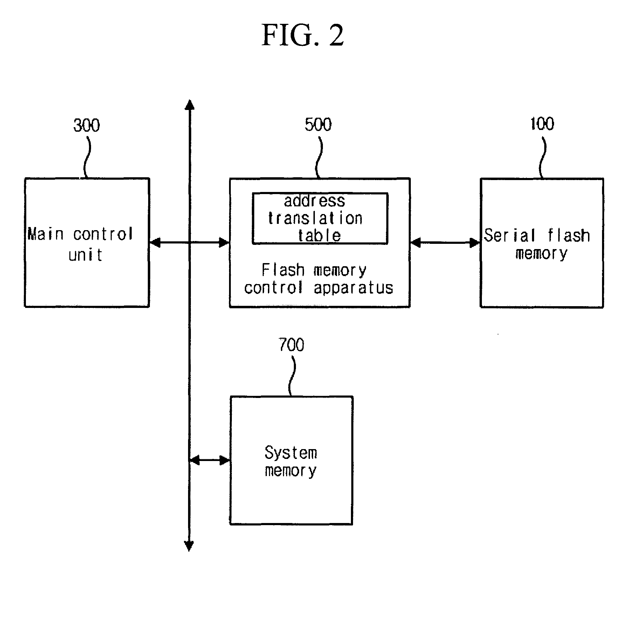

Figure 2 is a block diagram schematically showing the configuration of a serial flash access system according to one embodiment of the present invention.

As shown in Figure 2, the serial flash memory access system comprises a main control unit 300 that generates a write or delete command for the serial flash memory 100, a flash memory control apparatus 500 that performs operation control for supporting XIP in the serial flash memory 100 and directly accesses the serial flash memory 100 in response to a control command of the main control unit 300, and a system memory 700.

If power is applied to the flash memory control apparatus 500, the flash memory control apparatus 500 scans the spare region of the serial flash memory 100, generates a mapping table on which a current written status of the serial flash memory 100 is reflected, and then stores the table in a cache memory to refer to the table when accessing the serial flash memory 100.

Furthermore, when data at a given logical address are requested by the main control unit 300, the flash memory control apparatus 500 searches for desired data by referring to a first PAT.

Depending on the search results, the flash memory control apparatus 500 reads data at a corresponding logical address from the system memory 700 or the cache memory and transmits the read data to the main control unit 300, or reads pages containing corresponding data from the serial flash memory 100 and transmits the requested data to the main control unit 300.

Furthermore, the flash memory control apparatus 500 stores the pages read from the serial flash memory 100 in the system memory or the cache memory according to their priorities, and writes changed mapping information in the first PAT or second PAT.

For example, if the flash memory control apparatus 500 receives a control command, which indicates that the main control unit 300 intends to read data at a given logical address, from the main control unit 300, the flash memory control apparatus 500 searches for the requested logical address by referring to the first PAT and the second PAT.

As a result of the search, if information on the corresponding logical address is not found from the first PAT and the second PAT, the flash memory control apparatus 500 reads a page containing the desired data from the serial flash memory 100 and then transmits the corresponding data to the main control unit 300 through the read page.

The flash memory control apparatus 500 then stores the read page in the flash memory. At this time, if an index conflict occurs due to a page present in an index of the flash memory corresponding to the memory address of the read page, the apparatus 500 compares priorities of the previous page and the read page with each other.

As a result of the comparison, if the priority of the previous page is higher than that of the read page, the flash memory control apparatus 500 stores the read page in the system memory 700 and writes changed mapping information in the first PAT.

On the contrary, if the priority of the previous page is lower than that of the read page, the flash memory control apparatus 500 transfers the previous page stored in the cache memory to the system memory 700 to be stored therein and then writes changed mapping information in the first PAT. At the same time, the apparatus 500 stores the read page in the cache memory and then writes changed mapping information in the second PAT.

Generally, the system memory 700 may be RAM such as DRAM,SDRAM, SRAM, or UtRAM.

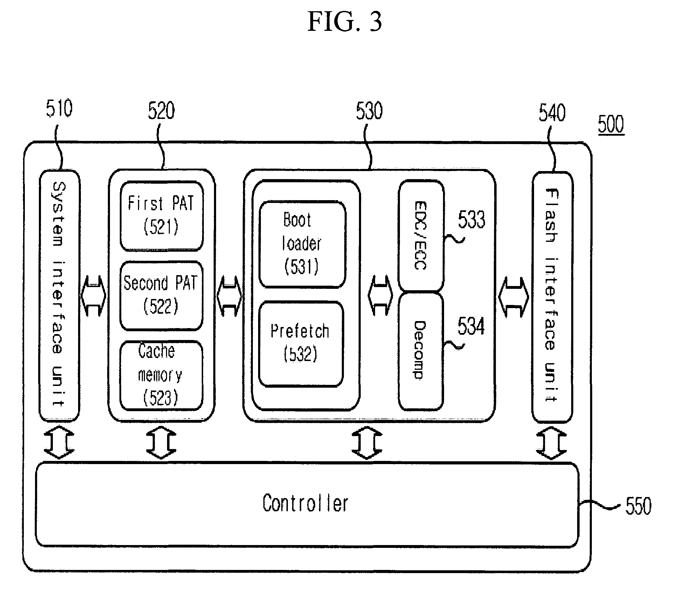

Figure 3 is a block diagram schematically showing the flash memory control apparatus shown in Figure 2.

As shown in Figure 3, the flash memory control apparatus 500 comprises a system interface unit 510, a cache module 520, an access module 530, a flash interface unit 540 and a controller 550.

The system interface unit 510 receives a control command generated from the main control unit 300 and processes transmission/reception of a signal for providing the main control unit 300 with the results of an operation in response to the received control command.

The cache module 520 comprises a first PAT 521, a second PAT 522 and a cache memory 523.

The first PAT 521 indicates the written status of the system memory 700. Mapping information between logical addresses and physical addresses of pages that are transferred from the cache memory 523 or the serial flash memory 100 to the system memory 700 to be stored therein is written in the first PAT 521.

Mapping information between logical addresses and physical addresses of pages that are transferred from the serial flash memory 100 to the cache memory 523 to be stored therein is written in the second PAT 522.

The cache memory 523 comprises a main cache (not shown), and a victim cache (not shown) that serves as a buffer for transferring data from the cache memory to a main storage device in order to reduce the occurrence of a cache miss. The cache memory 523 is usually implemented with L2-Cache that is an independent static random access memory (SRAM) chip.

The victim cache in accordance with the present invention stores a previously written page output according to a page replacement algorithm upon occurrence of an index conflict, thereby reducing the occurrence of a cache miss in the cache memory.

The access module 530 reads a page containing a boot code for initially booting the system for XIP in the serial flash memory 100, stores the read page, and then transmits the desired boot code to the main control unit 300. The access module 530 comprises a boot loader 531, a prefetch 532, an error detection code/error correction code (hereinafter, referred to as "EDC/ECC") 533 and Decomp 534.

The boot loader 531 facilitates efficient booting of the system. If power is applied, the boot loader 531 retrieves an OS program and an initialization code such as an image for system booting written in the boot region of the serial flash memory 100, and then stores them in a buffer. When the main control unit 300 starts a first code fetch cycle to request that the boot code be read, the boot loader 531 transmits the stored initialization code to the main control unit 300 so that booting can be started.

The prefetch 532, the EDC/ECC 533 and the Decomp 534 are provided to enhance the performance of the flash memory control apparatus 500. The prefetch 532 beforehand retrieves data, which are expected to be requested by the main control unit 300, from the serial flash memory 100 and then stores the data in the buffer. The EDC/ECC 533 detects/corrects errors in transmitted/received data. The Decomp 534 is responsible for data compression and decompression required depending on system requirements.

Since the Decomp 534 is provided depending on the system requirements, it may be omitted, if necessary.

The flash interface unit 540 performs transmission/reception of data to/from the serial flash memory 100 in response to the control command of the main control unit 300.

The controller 550 performs overall operation control so that XIP in the serial flash memory 100 can be achieved through the respective components. The controller 550 transmits desired data to the main control unit 300 by referring to the first and second PATs 521 and 522 and stores pages read from the serial flash memory 100 in the cache memory 523 or the system memory 700 according to their priorities.

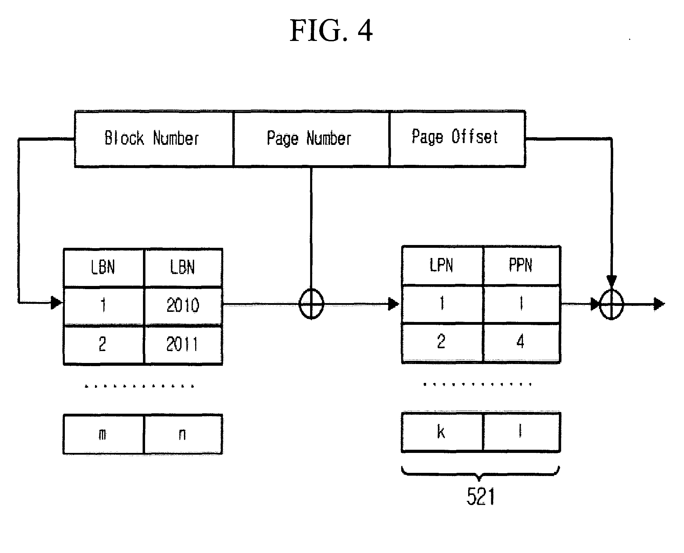

Figure 4 schematically shows a read command-processing configuration in the controller.

As shown in Figure 4, if a control command by which data written in the serial flash memory 100 will be read is received, from the main control unit 300, the controller 550 of the flash memory control apparatus 500 translates a logical address of the requested data into a physical address in order to access the data.

To this end, when the controller 550 receives the requested logical address from the main control unit 300, the controller 550 reads a logical block number (LBN) from the received logical address.

Then, the controller 550 accesses a mapping table stored in the cache memory 523 in an initialization process by using the read LBN and determines whether the LBN is a valid block in the mapping table. If it is determined that the LBN is a valid block, the controller 550 detects a physical block number (PBN) corresponding to the LBN through the mapping table.

On the contrary, if it is determined that the LBN is not a valid block in the mapping table, the controller 550 detects an alternative valid PBN.

Thereafter, the controller 550 detects a logical page number (LPN) from the received logical address, combines the detected LPN and PBN and then searches the first PAT 521 to determine whether a corresponding LPN is present therein.

As a result of the search, if the corresponding LPN is present in the first PAT 521, the controller 550 detects a physical page number (PPN) corresponding thereto.

Then, the controller 550 combines the detected PPN and a page offset to access the system memory 700 and then determines whether data written in a physical address of the system memory 700 corresponding to the PPN are valid values.

If it is determined that the data are valid values, the controller 550 reads data written in the corresponding physical address of the system memory 700 and then transmits the read data to the main control unit 300. If it is determined that the data are not valid values, the controller 550 determines that the page requested by the main control unit 300 is not present in the system memory 700.

If the page requested by the main control unit 300 is not present in the system memory 700 as described above, the controller 550 determines whether a physical page address (PPN) of data requested by the main control unit 300 is present in the cache memory 523, by referring to the second PAT 522.

If it is determined that the PPN is present in the cache memory 523, the controller 550 reads data written in a corresponding physical address of the cache memory 523 and then transmits the read data to the main control unit 300. If it is determined that the PPN is not present in the cache memory 523, the controller 550 accesses the serial flash memory 100 using the physical addresses (PBN and PPN).

Through the above procedures, the controller 550 can prevent waste of cycles resulting from repeated searches of the system memory 700 due to a cache miss occurring since desired data are not stored in the cache memory 523.

Further, since the chance of a cache miss is reduced through the victim cache of the cache memory 523, a cache hit rate in the controller 550 increases. Therefore, it is possible to provide real-time properties of the system.

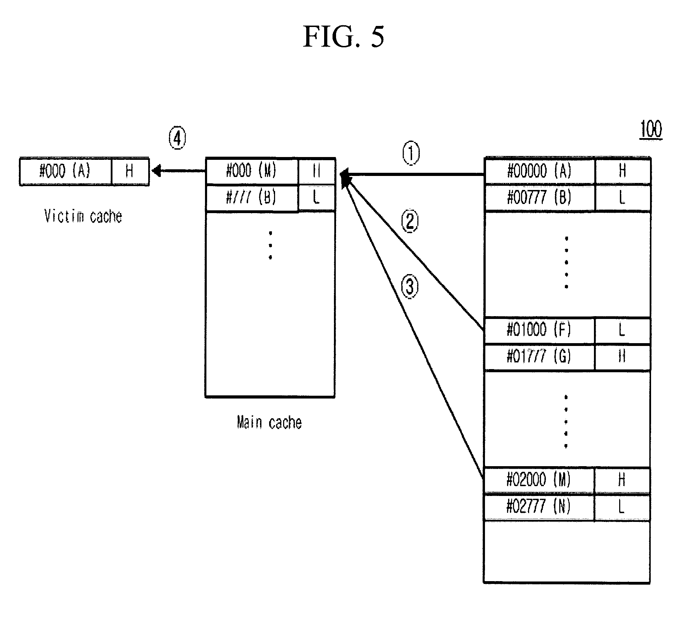

Figure 5 schematically shows a page-processing configuration depending on priority in the controller.

As shown Figure 5, when a page including predetermined data is read from the serial flash memory 100 in a read operation in response to a request of the main control unit 300, the controller 550 of the flash memory control apparatus 500 processes the read page according to its priority.

In other words, the controller 550 stores the read page in the cache memory 523 at an index address corresponding to a physical address in the serial flash memory 100, based on a direct mapping technique.

The controller 550 then determines whether index conflict occurs during the process of storing the read page in the cache memory 523. If an index conflict occurs, the controller 550 compares priorities of conflicting pages with each other and stores the read page in the cache memory 523 or the system memory 700.

For example, a page (A) of which a memory address is #00000 is stored in the cache memory 523 at an index address #000 corresponding thereto.

During this process, the controller 550 determines whether index conflict occurs.

If it is determined that an index conflict does not occur, the storage of the page (A) in the cache memory 523 is completed (①).

Thereafter, if data written in the serial flash memory 100 are sequentially requested by the main control unit 300, a page (F) of which a memory address is #01000 is stored in the cache memory 523 at the index address #000 corresponding thereto (②).

During this process, the controller 550 determines whether an index conflict occurs. Here, page (F) conflicts with page (A), which was previously written through the write operation.

If such a conflict occurs, the controller 550 compares the priorities of the pages (A) and (F) with each other.

As a result of the comparison, since the priority (L) of page (F) to be stored is lower than the priority (H) of page (A), the controller 550 stores the page (F) in the system memory 700 according to its priority.

Thereafter, the controller 550 reads relevant data from the serial flash memory 100 in response to sequential data requests by the main control unit 300. In this case, the controller 550 stores a page (M) of which a memory address is #02000 in the cache memory 523 at the index address #000 corresponding thereto (③).

During this process, the controller 550 determines whether an index conflict occurs. Here, again, page (M) conflicts with page (A), which was previously written through the write operation.

As was the case above, if such a conflict occurs, the controller 550 compares the priorities of pages (A) and (M) with each other.

As a result of the comparison, since the priority (H) of page (M) to be stored is the same as the priority (H) of page (A), the controller 550 transfers the previously written page (A) to the victim cache to be stored according to the page replacement algorithm (④) and stores the read page (M) at the index address #000 of the cache memory 523.

In the priority-based flash memory control apparatus 500 for XIP in the serial flash memory according to the present invention constructed as above, the serial flash memory 100 and the flash memory control apparatus 500 may be integrated into a single serial flash memory chip.

Such a serial flash memory chip can substitute for a ROM or NOR flash memory since it supports the XIP function. Further, the memory chip can perform the XIP function more efficiently through the memory management method based on the priority.

For reference, in the priority-based flash memory control apparatus for XIP in the serial flash memory according to the embodiment of the present invention described above, all the modules may be implemented with hardware or software, or some of them may be implemented with software.

Therefore, the fact that the priority-based flash memory control apparatus for XIP in the serial flash memory according to the embodiment of the present invention is implemented with hardware or software does not depart from the spirit and scope of the present invention. It will be apparent that changes and modifications involved in the implementation with hardware and/or software may be made thereto without departing from the spirit and scope of the present invention.

Hereinafter, a memory management method using the priority-based flash memory control apparatus for XIP in the serial flash memory constructed as above will be described in detail with reference to the accompanying drawings.

In the memory management method using the priority-based flash memory control apparatus for XIP in the serial flash memory, if power is applied, a page containing a boot code for booting the system is read from the serial flash memory 100 and is then buffered. When the main control unit 300 requests the boot code, the boot code is then transmitted to the main control unit. In such a manner, the memory management method is performed during the processing of a control command received from the main control unit 300 after completion of the initialization process of supporting XIP in the serial flash memory.

In other words, if data at a given logical address written in the serial flash memory 100 are requested by the main control unit 300 after the system is booted through the initialization process, the processing of the page read from the serial flash memory 100 is performed.

Therefore, in describing the memory management method using the priority-based flash memory control apparatus for XIP in the serial flash memory, detailed descriptions of the initialization process and processes related to write/delete operations, which are considered as departing from the scope of the present invention, will be omitted.

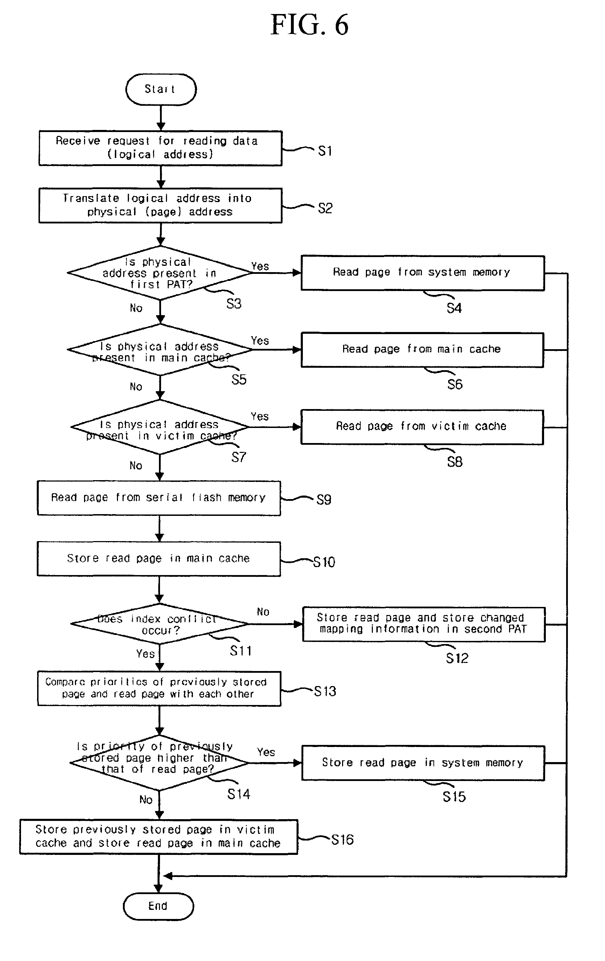

Figure 6 is a flowchart schematically illustrating a memory management method using the priority-based flash memory control apparatus for XIP in the serial flash memory according to one embodiment of the present invention.

As shown in Figure 6, if the controller 550 of the flash memory control apparatus 500 receives a request for reading data at a given logical address from the main control unit 300 (S1), it translates the requested logical address into a physical address by referring to a mapping table obtained from the serial flash memory 100 and the first PAT 521 (S2).

The controller 550 then determines whether a physical page address (PPN) of the data that the main control unit 300 requests to be read is present in the first PAT 521, by using the translated physical address (S3).

If it is determined that the physical address is present in the first PAT 521, the controller 550 accesses the system memory 700 and reads a page from the corresponding physical address of the system memory 700 (S4).

If it is determined that the physical address is not present in the first PAT 521, the controller 550 determines whether the physical address of the data that the main control unit 300 requests to be read is present in the main cache of the cache memory 523, by referring to the second PAT 522 (S5).

If it is determined that the corresponding physical address is present in the main cache, the controller 550 accesses the main cache by using the physical address and reads a page from the corresponding physical address of the main cache (S6).

On the contrary, if it is determined that the corresponding physical address is not present in the main cache, the controller 550 determines whether the physical address of the data that the main control unit 300 requests to read is present in the victim cache of the cache memory 523 (S7).

If it is determined that the corresponding physical address is present in the victim cache, the controller 550 accesses the victim cache by using the physical address and reads a page from the corresponding physical address of the victim cache (S8).

If the corresponding physical address is not present in the victim cache, the controller 550 accesses the serial flash memory 100 and reads a page from a corresponding physical address of the serial flash memory 100 (S9).

The controller 550 then stores the read page in the main cache of the cache memory 523 at an index address corresponding to the physical address in the serial flash memory 100 according to the direct mapping technique (S10).

Thereafter, the controller 550 determines whether an index conflict occurs between the page to be written and a page that was previously stored in the main cache at the corresponding index address (S11).

If it is determined that there is no index conflict, the controller 550 completes the storage of the page in the main cache and writes changed mapping information in the second PAT 522 (S12).

If it is determined that there is an index conflict, the controller 550 compares the priorities of the previously stored page and the read page with each other (S13). Based on the comparison results, the controller 550 determines whether the priority of the previously stored page is higher than that of the read page (S14).

If it is determined that the priority of the previously stored page is higher than that of the read page, the controller 550 stores the read page in the system memory 700 and writes changed mapping information in the first PAT 521 (S15).

On the contrary, if the priority of the previously stored page is lower than that of the read page, the controller 550 transfers the previously stored page to the victim cache of the cache memory 523 to be stored therein, and then stores the read page in the main cache of the cache memory 523.

Further, the controller 550 writes changed mapping information in the second PAT 522 (S16).

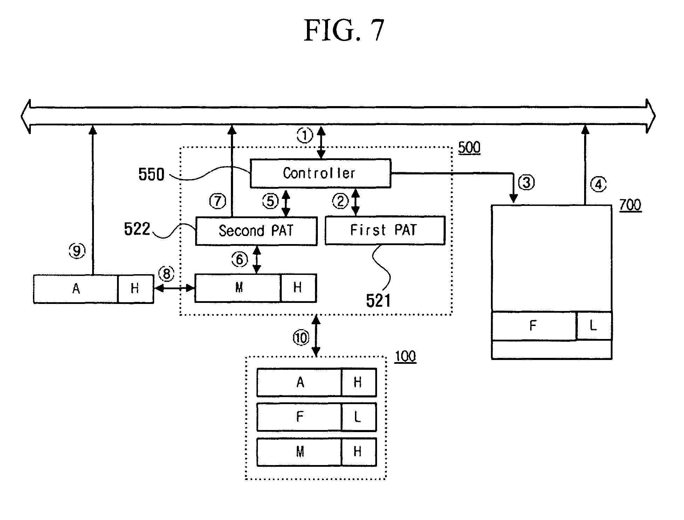

The memory management method using the priority-based flash memory control apparatus for XIP in the serial flash memory according to the embodiment of the present invention will be described in detail by way of example with reference to Figure 7.

Figure 7 is a block diagram schematically showing a memory management configuration using the priority-based flash memory control apparatus for XIP in the serial flash memory according to an embodiment of the present invention.

As shown in Figure 7, if the controller 550 of the flash memory control apparatus 500 receives a control command by which predetermined data written in the serial flash memory 100 will be read, from the main control unit 300 (①), it searches the system memory 700 to determine whether a physical address of the requested data is present in the system memory 700, by referring to the first PAT 521 (②).

As a result of the search, if a corresponding physical address is present in the system memory 700, the controller 550 accesses the system memory 700 by using the physical address of the requested data (③), reads the data at the corresponding physical address from the system memory 700, and then transmits the read data to the main control unit 300 (④).

On the contrary, if the corresponding physical address is not present in the system memory 700, the controller 550 searches the main cache of the cache memory 523 to determine whether the physical address of the requested data is present in the main cache of the cache memory 523, by referring to the second PAT 522 (⑤).

As a result of the search, if the corresponding physical address is present in the main cache, the controller 550 accesses the main cache by using the physical address of the requested data (⑥), reads data at the corresponding physical address from the main cache, and then transmits the read data to the main control unit 300 (⑦).

On the contrary, if the corresponding physical address is not present in the main cache, the controller 550 accesses the victim cache by using the physical address of the requested data (⑧).

Thereafter, the controller 550 determines whether the corresponding physical address is present in the victim cache. If the corresponding physical address is present in the victim cache, the controller 550 reads data at the corresponding physical address from the victim cache and then transmits the read data to the main control unit 300 (⑨). If the corresponding physical address is not present in the victim cache, the controller 550 accesses the serial flash memory 100 by using the physical address ( 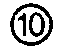 ).

Then, the controller 550 reads a page containing the requested data from the serial flash memory 100 and transmits the requested data to the main control unit 300. Further, the controller 550 stores pages read from the serial flash memory 100 in the cache memory 523 or the system memory 700 according to their priorities.

Furthermore, the controller 550 writes changed mapping information in the first PAT 521 or the second PAT 522.

Although the priority-based flash memory control apparatus 500 for XIP in the serial flash memory, the memory management method using the same, and the memory chip thereof according to the present invention have been described as being implemented with the flash memory control apparatus 500 including the first PAT 521, the first PAT 521 may be implemented in a given memory space on a system such as the system memory 700 other than the flash memory control apparatus 500.

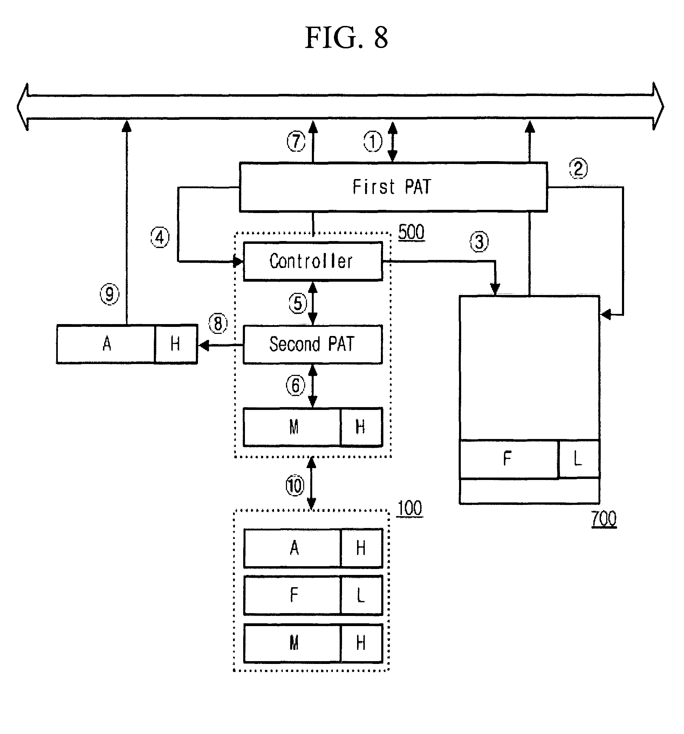

Figure 8 is a block diagram schematically showing a memory management configuration using the priority-based flash memory control apparatus for XIP in the serial flash memory according to a further embodiment of the present invention.

As shown in Figure 8, even in a case where the first PAT 521 is separated from the cache module 520 and independently located in the system memory, the same priority-based flash memory management process as described with reference to Figure 7 is performed.

According to the present invention described above, pages read from a serial flash memory are stored in a system memory or a cache memory according to their priorities that are assigned thereto in advance. Therefore, the present invention provides a method of efficiently managing a memory by preventing undesired data from being accumulated in the cache memory.

Furthermore, according to the present invention, data are accumulated in a maximum length in a cache memory to prevent the occurrence of a cache miss in the cache memory. Therefore, there are advantages in that the performance of code execution of a controller can be maximized and the miss ratio of the cache memory can be reduced.

According to the present invention, since the miss ratio of the cache memory is reduced, waste of cycles can be prevented. Thus, there is an advantage in that the real-time properties of a system can be maintained.

In addition, according to the present invention, a memory with a capacity smaller than that of a cache memory with the same performance is required. Thus, the present invention has an advantage in that it is possible to reduce costs for designing a system and improve the performance of the system.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A serial flash memory, comprising:
a sector representing a data region which comprises a plurality of pages and in which data are stored; and
a sector representing a spare region having information on logical addresses of the data region,
wherein each of the pages comprises a data section with main data written therein and a spare section in which priorities assigned to the main data are written.

2. The serial flash memory as claimed in claim 1, wherein the priority is determined based on at least one of a ratio of access to the main data of each page and significance of the main data of the page.

3. A priority-based flash memory control apparatus for XIP in a serial flash memory, wherein:
when a main control unit (300) requests data at a given logical address, the requested data are searched for by referring to a predetermined address translation table, and
depending on the results of the search, the corresponding data are read from a system memory (700) or a cache memory (523) and then transmitted to the main control unit (300), or a page containing the corresponding data is read from the serial flash memory (100) and then transmitted to the main control unit (300).

4. The apparatus as claimed in claim 3, wherein the page read from the serial flash memory (100) is stored in the system memory (700) or the cache memory (523) according to its priority and changed mapping information is written in the address translation table.

5. The apparatus as claimed in claim 4, wherein if an index conflict occurs during the process of writing the read page in the flash memory, the read page is stored in the system memory (700) or the cache memory (523) according to its priority by comparing the priorities of a previously stored page and the read page, and by storing the read page in the system memory (700) if the priority of the previously stored page is higher than that of the read page or by transferring the previously stored page to a victim cache and storing the read page in a main cache if the priority of the previously stored page is not higher than that of the read page.

6. The apparatus as claimed in claim 3, 4 or 5, wherein the address translation table comprises:
a first PAT (521) in which mapping information on pages stored in the system memory (700) is written; and
a second PAT (522) in which mapping information on pages stored in the cache memory (523) is written.

7. The apparatus as claimed in claim 6, wherein the first PAT (521) is located in the system memory (700).

8. The apparatus as claimed in claim 6 or 7, wherein the second PAT (522) is located in a cache module (520).

9. The apparatus as claimed in any of claims 3 to 8, further comprising:
a cache module (520) that stores pages read from the serial flash memory (100) in the cache memory (523) and has the address translation table in which mapping information on the read pages is written; and
a controller (550) that transmits data requested by the main control unit (300) by referring to the address translation table and stores the pages read from the serial flash memory (100) in the cache memory (523) or the system memory (700) according to their priorities.

10. The apparatus as claimed in claim 9, further comprising:
a system interface unit (510) operable to receive a control command from the main control unit (300) and transmit the results of an operation in response to the received control command;
an access module (530) operable to read a boot code written in the serial flash memory (100) and store the read boot code in a buffer, said access module (530) comprising a boot loader operable to transmit a boot code as soon as the main control unit (300) requests the boot code, thereby enabling XIP in the serial flash memory (100); and
a flash interface (540) operable to transmit transmission and reception of data to and from, respectively, the serial flash memory (100) in response to a control command of the main control unit (300).

11. The apparatus as claimed in any of claims 3 to 10, wherein the priority is determined based on at least one of a ratio of access to the main data of each page and significance of the main data of the page.

12. A flash memory chip, comprising:
a serial cell-type serial flash memory (100) that consists of pages each of which has a data section in which main data are written and a spare section in which priorities assigned to the main data are written; and
a flash memory control apparatus (500) operable to store pages read from the serial flash memory (100) in a system memory (700) or a cache memory (523) according to their priorities and writing changed mapping information in a predetermined address translation table.

13. The flash memory chip as claimed in claim 12, wherein the flash memory control apparatus (500) is operable to search for data at a given logical address requested by a main control unit (300) by referring to the address translation table, and read the corresponding data from the system memory (700) or the cache memory (523) and transmit the data to the main control unit (300) or read a page containing the corresponding data from the serial flash memory (100) and transmit the page to the main control unit (300) depending on the results of the search.

14. A priority-based flash memory management method for XIP in a serial flash memory, comprising:
if a request for reading data at a given logical address is received from a main control unit (300), searching for the data at the corresponding logical address by referring to a predetermined address translation table; and
reading the data at the corresponding logical address from a system memory (700) or a cache memory (523) and transmitting the read data to the main control unit (300), depending on the results of the search.

15. The method as claimed in claim 14, further comprising reading a page containing the corresponding data from the serial flash memory (100) and transmitting the requested data to the main control unit (300), depending on the results of the search.

16. The method as claimed in claim 15, further comprising storing the page read from the serial flash memory (100) in the system memory (700) or the cache memory (523) according to its priority and writing changed mapping information in the address translation table.

17. The method as claimed in claim 14, 15 or 16, wherein the address translation table comprises:
a first PAT (521) in which mapping information on pages stored in the system memory (700) is written; and
a second PAT (522) in which mapping information on pages stored in the cache memory (523) is written.

18. The method as claimed in claim 16 or 17, wherein the step of storing the read page in the system memory (700) or the cache memory (523) according to its priority, comprises:
determining whether an index conflict occurs during the process of writing the read page in the flash memory;
if it is determined that an index conflict does not occur, storing the read page in the flash memory, or if an index conflict occurs, comparing the priorities of a previously stored page and the read page with each other; and
if it is determined that the priority of the previously stored page is higher than that of the read page, storing the read page in the system memory (700), or if the priority of the previously stored page is not higher than that of the read page, transferring the previously stored page to a victim cache and storing the read page in a main cache.

19. The method as claimed in claim 16, 17 or 18, wherein the priority is determined based on at least one of a ratio of access to the main data of each page and significance of the main data of the page.
